# FASCICULE DE BREVET EUROPEEN

(11) **EP 2 897 448 B1**
(45) Date de publication et mention de la délivrance du brevet: **22.02.2017**
(21) Numéro de dépôt: 14197485.7
(22) Date de dépôt: 11.12.2014
(51) Int. Cl.: H05K 7/20, F04D 25/14

(54) **Système de ventilation pour châssis d'équipement informatique**
Belüftungssystem für Gehäuse eines IT-Geräts
Ventilation system for computer chassis

(30) Priorité: 17.01.2014 FR 1450386
(43) Date de publication de la demande: 22.07.2015
(73) Titulaire: Freebox SAS, 75016 Paris (FR)
(72) Inventeur: Delecourt, Arnaud, 93160 Noisy-Le-Grand (FR)
(74) Mandataire: Dupuis-Latour, Dominique

(56) Documents cités:
- US-A- 5 890 959
- US-A- 6 031 717
- US-A- 6 135 875
- US-A1- 2006 016 482
- US-A1- 2013 065 501

## Description

L'invention concerne les équipements de réseau modulaires, en particulier les équipements tels que ceux utilisés dans les installations à grande échelle telles que grappes de serveurs, réseaux de télécommunications, routeurs... mises en oeuvre par les hébergeurs web, les fournisseurs d'accès Internet, les centres de stockage et de traitement de données de type *datacenter,* etc.

Ces équipements modulaires se présentent souvent sous la forme de châssis installés dans des baies, chaque châssis pouvant comporter un grand nombre d'équipements (serveurs, commutateurs ou *switches,* multiplexeurs de type DSLAM, unités de stockage de masse, etc.) très densément logés dans le châssis.

La chaleur dégagée par ces équipements doit être évacuée en permanence par des moyens de ventilation puissants, de manière à éviter toute montée en température excessive. La ventilation de ces installations est un aspect particulièrement important pour garantir en toutes circonstances le bon fonctionnement des équipements et donc la continuité du service rendu aux clients et utilisateurs.

Les US 6 135 875 A, US 2006/016482 A1, US 2013/065501 A1, US 5 890 959 A et US 6 031 717 A décrivent de tels systèmes de ventilation pour équipements informatiques.

Les deux contraintes majeures à respecter pour ces systèmes sont le débit d'extraction d'air, qui doit être très élevé, et la compacité mécanique, car l'emprise du système de ventilation sur le volume utile du châssis doit être la plus faible possible.

Pour ce faire, les systèmes de ventilation comprennent généralement des batteries de ventilateurs, notamment à flux axial, opérant en parallèle, ces ventilateurs étant juxtaposés pour constituer un panneau plat d'extraction d'air comportant par exemple trois ou quatre ventilateurs montés côte à côte, ou un réseau bidimensionnel de 3 x 3 ou 4 x 4 ventilateurs. Ce panneau d'extraction d'air peut même se présenter sous forme d'un tiroir extractible ou *fan rack* inséré dans un emplacement correspondant du châssis.

La multiplication des ventilateurs permet d'assurer le débit d'extraction d'air voulu en respectant les contraintes de compacité du fait de la faible épaisseur du panneau, mais cette solution devient un point faible en cas de panne d'un des ventilateurs de la batterie de ventilateurs.

En effet, non seulement le ventilateur en panne n'extrait plus d'air du volume intérieur du châssis (ce qui réduit proportionnellement le débit d'air utile), mais en outre et surtout il devient une entrée d'air pour les ventilateurs voisins en fonctionnement, de sorte que ces derniers vont en fait brasser un important flux d'air (froid) entrant par l'ouverture du ventilateur en panne, en n'aspirant plus qu'une partie du volume d'air (chaud) du volume intérieur du châssis qu'ils aspiraient auparavant. Ainsi, non seulement le flux aspiré sera globalement moindre (du fait de la panne de l'un des ventilateurs), mais le ventilateur défaillant, par effet de boucle, va perturber le fonctionnement des autres ventilateurs, pour lesquels l'extraction d'air chaud deviendra bien moins efficace.

Ce phénomène devient particulièrement critique dans une configuration à deux ventilateurs, car dans ce cas la majeure partie de l'air aspiré par le ventilateur resté fonctionnel sera de l'air aspiré depuis l'ouverture du ventilateur voisin en panne. Le flux d'air chaud réellement extrait du volume intérieur du châssis sera alors très faible, et la température des circuits va vite monter et atteindre les seuils de sécurité.

Les équipements sont bien entendu pourvus de système de surveillance permettant de détecter ces températures excessives, d'alerter un opérateur et d'arrêter ou ralentir le fonctionnement des circuits dans l'attente d'une intervention - mais entretemps le fonctionnement de l'équipement aura dû être interrompu ou fortement dégradé.

L'un des buts de l'invention est de remédier à cette difficulté, en proposant un moyen d'empêcher un ventilateur en panne dans une batterie de ventilateurs de perturber le fonctionnement des ventilateurs voisins, de manière que ces derniers continuent à fournir leur plein débit d'extraction d'air chaud, sans fuite d'entrée d'air dans le châssis à ventiler.

Concrètement, comme les batteries de ventilateurs sont habituellement dimensionnées avec une marge de sécurité importante par rapport aux besoins réels en régime permanent, la défaillance d'un seul ventilateur ne devrait pas empêcher l'équipement de continuer à fonctionner normalement, permettant ainsi d'assurer la continuité du service jusqu'à l'intervention d'un opérateur pour l'échange du ventilateur défaillant.

On verra également que la solution proposée par l'invention est parfaitement compatible avec les impératifs de compacité du système de ventilation, grâce à une très faible emprise additionnelle, et au surplus une très grande simplicité sur le plan mécanique, ne risquant pas de grever les couts de fabrication du système de ventilation.

Plus précisément, l'invention propose un châssis d'équipement informatique, d'un type général connu tel que divulgué par le US 6 135 875 A précité et correspondant au préambule de la revendication 1.

La partie caractérisante de la revendication 1 expose les éléments spécifiques à l'invention. Les sous-revendications visent des modes de réalisation particuliers.

On va maintenant décrire des exemples de mise en oeuvre de l'invention, en référence aux dessins annexés où les mêmes références désignent d'une figure à l'autre des éléments identiques ou fonctionnellement semblables.
Les Figures 1 a et 1 b sont des représentations schématiques, vues de dessus, illustrant le flux d'air dans un châssis pourvu d'une batterie de ventilateurs d'extraction d'air, respectivement avec tous les ventilateurs en fonctionnement normal et avec l'un des ventilateurs en panne.
La Figure 2 illustre le placement de la plaque antiretour selon l'invention par rapport à une batterie de ventilateurs telle que celle de la Figure 1a.
Les Figures 3a et 3b sont des vues, respectivement de côté et de face d'une plaque antiretour selon un premier mode de réalisation de l'invention.
Les Figures 4a et 4b sont des vues de détail illustrant le fonctionnement de la plaque antiretour des Figures 3a et 3b, respectivement en position ouvrante et en position obturante.
Les Figures 5a et 5b sont des vues, respectivement de côté et de face d'une plaque antiretour selon un second mode de réalisation de l'invention.
Les Figures 6a et 6b sont des vues de détail illustrant le fonctionnement de la plaque antiretour des Figures 5a et 5b, respectivement en position ouvrante et en position obturante.

Sur les figures, la référence 10 désigne de façon générale un châssis ou boitier enfermant un équipement électronique 12, par exemple un commutateur ou *switch,* un multiplexeur DSLAM, etc. Les circuits de cet équipement dégagent en fonctionnement une quantité de chaleur importante, qu'il convient d'évacuer pour maintenir les circuits à une température de fonctionnement satisfaisante et éviter l'apparition de points chauds susceptibles de détériorer les circuits ou de déclencher une alarme conduisant à une interruption de fonctionnement de l'appareil.

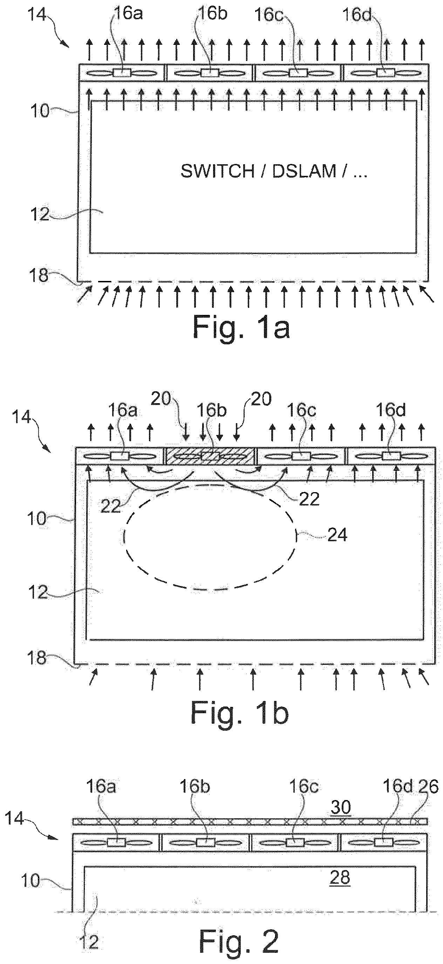

Pour ce faire, l'une des faces du boitier 10 est pourvue d'une batterie 14 de ventilateurs, par exemple une pluralité de ventilateurs à flux axial 16a, 16b, 16c, 16d ... juxtaposés côte à côte pour former une rangée ou un panneau bidimensionnel de grande dimension, constituant une face d'extraction d'air du boitier. Sur une autre face du boitier sont disposées des entrées d'air 18 de sorte que, en fonctionnement normal (comme illustré sur la Figure 1a), de l'air frais pénètre par les entrées d'air 18, vient refroidir les circuits de l'équipement 12 puis est aspiré par la batterie de ventilateurs 14 qui refoulent l'air chaud vers l'extérieur du boitier 10.

La configuration en batterie de ventilateurs individuels alignés ou disposés en un réseau permet d'effectuer l'extraction d'air sur une large surface de l'un des côtés du boitier 10, tout en conservant une compacité importante du fait de la faible épaisseur de chacun des ventilateurs individuels, pour un flux d'air extrait globalement équivalent.

Cette configuration présente cependant un inconvénient, illustré Figure 1 b : si l'un des ventilateurs tombe en panne, par exemple le ventilateur 16b, celui-ci, bien entendu, ne va plus extraire d'air depuis l'intérieur du boitier, mais va de plus se comporter comme une entrée d'air de sorte que les ventilateurs voisins 16a et 16c vont, pour une grande partie, aspirer de l'air extérieur via l'ouverture du ventilateur 16b en panne (flèches 20, 22) au lieu d'extraire de l'air chaud depuis le volume intérieur du boitier.

Ainsi, l'efficacité de la ventilation sera non seulement amoindrie par la panne de l'un des ventilateurs, mais également dégradée pour les ventilateurs restant en fonctionnement, de sorte que globalement la ventilation devient largement moins efficace, avec le risque de création d'une zone chaude 24 du circuit 12, pouvant conduire à une alarme de température et donc une interruption du fonctionnement de l'équipement.

Pour pallier cet inconvénient, l'invention propose, comme illustré Figure 2, d'associer à la batterie de ventilateurs 14 une "plaque antiretour" autorisant le passage d'un flux d'air depuis le côté interne 28 du boitier vers le côté externe 30, mais interdisant tout retour d'air dans le sens inverse. Cette plaque antiretour aura donc pour fonction de fermer la surface d'un ventilateur en panne en évitant que l'air n'y entre depuis le côté externe, de manière à conserver le débit complet des autres ventilateurs, sans fuite d'entrée d'air dans le système à ventiler.

Les clapets antiretour traditionnels sont souvent constitués d'une mécanique complexe de volets basculants montés sur un axe, qui s'ouvrent quand le flux d'air les pousse et se ferment par gravité, par ressort ou simplement par inversion du flux d'air. Ces clapets antiretour conventionnels sont constitués de nombreuses pièces complexes et nécessitent un assemblage mécanique long et minutieux. Ils présentent en outre un encombrement physique non négligeable en épaisseur en particulier, qui empêche de les utiliser dans des systèmes très compacts comme les châssis d'équipements électroniques.

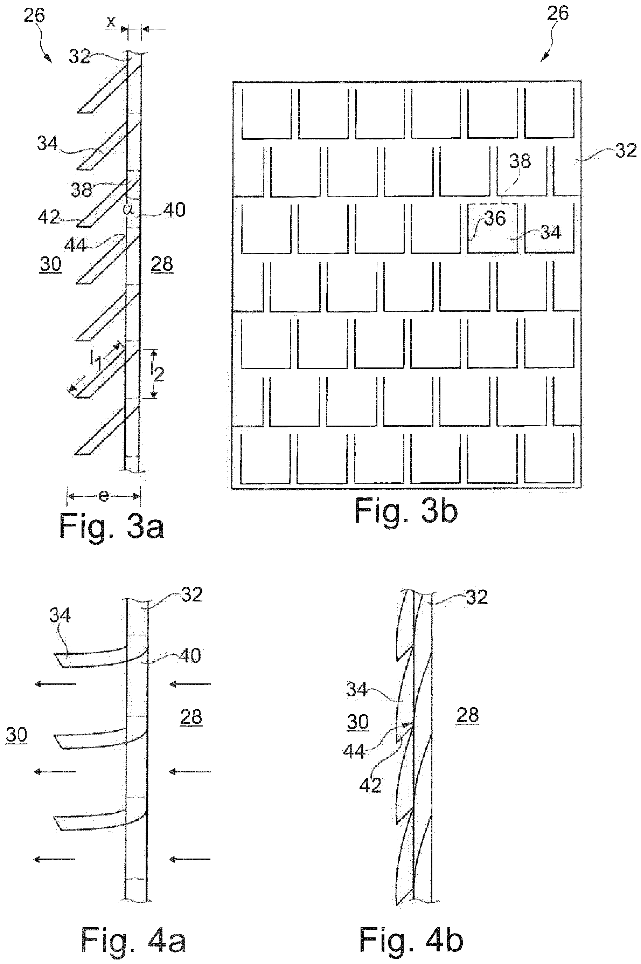

Pour pallier cet inconvénient, l'invention propose une structure particulière de plaque antiretour, illustrée sur les Figures 3a, 3b, 4a et 4b (pour un premier mode de réalisation) et 5a, 5b, 6a et 6b (pour un second mode de réalisation).

Le principe de base, commun à tous les modes de réalisation, consiste à utiliser une feuille monobloc 32 en un matériau souple, par exemple en silicone, de faible épaisseur (typiquement de l'ordre de 1/3 mm), qui sera disposée contre la face d'extraction d'air, c'est-à-dire contre la batterie de ventilateurs 14 côté externe (comme illustré Figure 2). En variante, il est également possible de placer cette plaque antiretour côté amont, c'est-à-dire entre l'entrée d'air du système et l'entrée d'air des ventilateurs.

La feuille monobloc 32 comporte un réseau bidimensionnel de volets élémentaires 34 en forme d'écailles ou tuiles de très faible dimension (quelques millimètres à quelques centimètres de côté, cette dimension devant être notablement inférieure à celle d'un ventilateur). Chacun de ces volets est constitué par une petite lame mince et plate, juxtaposée avec les autres, et définie par une entaille de la feuille de matériau souple, cette entaille pouvant être venue de moulage, découpée, estampée, etc. Chaque volet est défini par un contour 36, par exemple formé sur les trois côtés d'un carré comme dans les exemples illustrés, avec un quatrième côté 38 du côté qui n'est pas entaillé et forme ainsi un pont de matière reliant la surface du volet au reste de la feuille 32 avec possibilité de déformation, ce pont de matière 38 agissant à la manière d'une charnière.

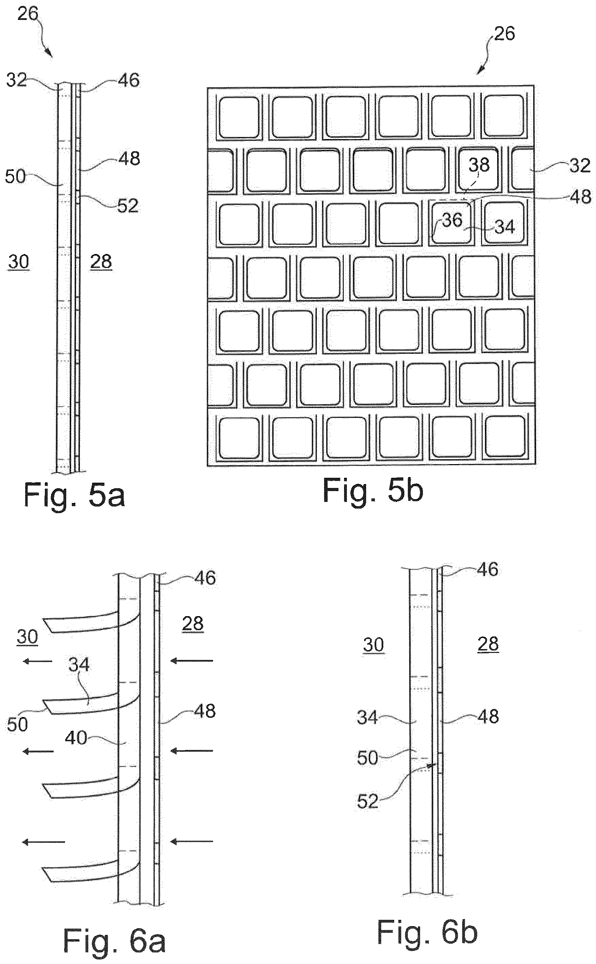

Chaque volet 34 peut être ainsi déformé, sous l'effet d'un gradient de pression appliqué entre le côté interne 28 et le côté externe 30 de la feuille, entre une position ouvrante (illustrée Figures 4a et 6a) dégageant un passage d'air 40 entre côté interne 28 et côté externe 30, et une position obturante (illustrée Figures 4b et 6b) où le volet n'est pas courbé, ou moins courbé que dans la position ouvrante, et où son bord libre 42 vient en contact avec le reste de la feuille 32, occultant ainsi le passage d'air 40.

Dans le mode de réalisation des Figures 3a, 3b, 4a et 4b, la longueur *l₁* de la partie libre des volets est supérieure à la dimension correspondante /*₂* de l'ouverture de la feuille 32, ce qui peut être obtenu en réalisant la feuille 32 avec la configuration illustrée Figure 3a venue directement de moulage, c'est-à-dire avec des volets élémentaires 34 moulés de manière à former à l'état libre un angle a par rapport au plan du reste de la feuille. La feuille venue de moulage se présente donc, en l'absence de contrainte extérieure, sous la forme illustrée Figures 3a, avec une dimension hors tout e inférieure à 3 mm pour une épaisseur de feuille x de l'ordre de 1/3 mm.

En présence d'un gradient de pression dirigé du côté interne 28 vers le côté externe 30 (Figure 4a), les volets 34 dégagent le passage d'air 40, tandis qu'en l'absence de gradient, ou avec un gradient inverse (contre-pression côté externe 30) les volets 34 se ferment (Figure 4b) par gravité et/ou du fait de la contre-pression, le bord libre 42 venant alors en butée contre le bord 44 en vis-à-vis de la plaque 32.

Dans le second mode de réalisation, illustré Figures 5a, 5b, 6a et 6b, les volets 34 sont définis par un estampage de la feuille 32, et leur longueur est donc la même que celle de l'ouverture correspondante de la feuille. La feuille découpée 32 est dans ce cas associée à une contre-feuille rigide 46 comprenant des ouvertures 48 chacune de dimension légèrement inférieure au passage d'air 40, de manière à laisser subsister le long de tout ou partie du contour 36 du volet une surface de butée 52 contre laquelle viendra appuyer le bord libre 50 du volet 34 en présence d'une contre-pression entre le côté externe 30 et le côté interne 28 (cette situation est illustrée Figure 6b).

De façon générale, quels que soient les détails de réalisation, on constatera que la solution de l'invention présente une multiplicité d'avantages, notamment :
- très faible cout de réalisation ;
- silence de fonctionnement ;
- absence de risques de grippage, etc. (à la différence des clapets mécaniques articulés) ;
- possibilité de conditionnement en une feuille de grande dimension, découpable pour l'adapter aux différents panneaux de ventilateurs utilisés ;
- très faible encombrement en épaisseur ; et
- possibilité d'adjonction aisée à des systèmes déjà existants, dans la mesure où il n'est pas nécessaire de modifier le système de ventilation.

## Revendications

1. Un châssis (10) d'équipement informatique, ce châssis comprenant une face d'extraction d'air apte à recevoir une batterie de ventilateurs (16a, 16b, 16c, 16d) juxtaposés, les ventilateurs étant aptes à créer un flux d'air unidirectionnel depuis un côté interne (28) du châssis vers un côté externe (30) de ce même châssis,
le châssis comportant une plaque antiretour (26) disposée contre la face d'extraction d'air, cette plaque antiretour comprenant une feuille monobloc (32) en matériau souple configurée en un réseau bidimensionnel de volets élémentaires (34) déformables, non articulés, définis chacun par une entaille de la feuille de matériau souple le long d'un contour non fermé (36) laissant subsister entre le volet élémentaire et le reste de la feuille un pont de matière (38), le contour de la région entaillée définissant un passage d'air (40) et chaque volet élémentaire étant déformable entre :
• une position ouvrante où le volet élémentaire est courbé vers le côté externe en éloignement du reste de la feuille, dégageant ainsi le passage d'air (40) formé par la région entaillée de la feuille,
la plaque antiretour laissant alors passer le flux d'air du côté interne vers le côté externe du châssis sous l'effet d'une surpression côté interne ; et
• une position obturante où le volet élémentaire n'est pas courbé, ou moins courbé que dans la position ouvrante, la plaque antiretour bloquant alors tout flux d'air entre le côté interne et le côté externe du châssis sous l'effet d'une contre-pression côté externe,
***caractérisé en ce que*** la feuille monobloc (32) de la plaque antiretour (26) est montée contre la face d'extraction d'air du châssis de manière à couvrir l'ensemble des ventilateurs de ladite batterie de ventilateurs juxtaposés,
*et **en ce qu'**en* position obturante le contour (36) du volet élémentaire est en contact avec le contour homologue de la feuille, occultant ainsi le passage d'air formé par la région entaillée de la feuille.

2. Le châssis de la revendication 1, dans lequel chaque volet individuel (34) forme, à l'état libre, un angle (α) par rapport au plan du reste de la feuille (32), chaque volet individuel présentant une longueur (l₁) supérieure à la longueur (l₂) du bord homologue de la région entaillée de la feuille.

3. Le châssis de la revendication 1, dans lequel chaque volet individuel (34) est, à l'état libre, coplanaire avec le reste de la feuille (32), chaque volet individuel présentant une longueur égale à la longueur du bord homologue de la région entaillée de la feuille,
et dans lequel la plaque antiretour comprend en outre, côté interne, une contre-feuille (46) en matériau rigide avec des ouvertures (48) homologues des passages d'air de la feuille en matériau souple, ces ouvertures portant une butée (52) telle que le bord libre (50) du volet élémentaire en vis-à-vis de l'ouverture vienne en contact avec cette butée dans la position obturante du volet élémentaire.

## Patentansprüche

1. Gehäuse (10) für eine Computerausrüstung, wobei das Gehäuse eine Luftabzugsfläche umfasst, die zum Aufnehmen eines Sets aneinandergereihter Lüfter (16a, 16b, 16c, 16d) eingerichtet ist, wobei die Lüfter dazu eingerichtet sind, einen unidirektionalen Luftstrom von einer Innenseite (28) des Gehäuses zu einer Außenseite (30) des gleichen Gehäuses hin zu erzeugen,
wobei das Gehäuse eine Rückstromsperrplatte (26) aufweist, die gegen die Luftabzugsfläche angeordnet ist, wobei diese Rückstromsperrplatte eine einteilige Folie (32) aus flexiblem Material umfasst, die als ein bidimensionales Netz aus verformbaren, nicht gelenkigen Elementarklappen (34) ausgebildet ist, die jede durch eine Einkerbung der Folie aus flexiblem Material entlang einer nicht geschlossenen Kontur (36) definiert sind, die zwischen der Elementarklappe und der übrigen Folie eine Materialbrücke (38) bestehen lässt, wobei die Kontur des eingekerbten Bereichs einen Luftdurchlass (40) definiert und jede Elementarklappe verformbar ist zwischen:
• einer öffnenden Stellung, in der die Elementarklappe zu der Außenseite hin von der übrigen Folie weg gekrümmt ist und so den Luftdurchlass (40) freigibt, der durch den eingekerbten Bereich der Folie gebildet ist,
wobei die Rückstromsperrplatte unter der Einwirkung eines Überdrucks auf der Innenseite so den Luftstrom von der Innenseite zu der Außenseite des Gehäuses hin passieren lässt; und
• einer verschließenden Stellung, in der die Elementarklappe nicht gekrümmt ist, oder weniger gekrümmt ist als in der öffnenden Stellung, wobei die Rückstromsperrplatte unter der Einwirkung eines Gegendrucks auf der Außenseite dann den gesamten Luftstrom zwischen der Innenseite und der Außenseite des Gehäuses sperrt,
**dadurch gekennzeichnet, dass** die einteilige Folie (32) der Rückstromsperrplatte (26) gegen die Luftabzugsfläche des Gehäuses in der Form montiert ist, dass sie sämtliche Lüfter des Sets aneinandergereihter Lüfter bedeckt,
und dadurch, dass in der verschließenden Stellung die Kontur (36) der Elementarklappe in Kontakt mit der entsprechenden Kontur der Folie ist, wodurch sie den Luftdurchlass verdeckt, der durch den eingekerbten Bereich der Folie gebildet ist.

2. Gehäuse nach Anspruch 1, wobei jede einzelne Klappe (34) im freien Zustand einen Winkel (α) relativ zu der Ebene der übrigen Folie (32) bildet, wobei jede einzelne Klappe eine Länge (11) aufweist, die größer als die Länge (12) des entsprechenden Rands des eingekerbten Bereichs der Folie ist.

3. Gehäuse nach Anspruch 1, wobei jede einzelne Klappe (34) im freien Zustand mit der übrigen Folie (32) koplanar ist, wobei jede einzelne Klappe eine Länge aufweist, die gleich der Länge des entsprechenden Rands des eingekerbten Bereichs der Folie ist,
und wobei die Rückstromsperrplatte ferner, auf der Innenseite, eine Gegenfolie (46) aus steifem Material mit Öffnungen (48) aufweist, die den Luftdurchlässen der Folie aus flexiblem Material entsprechen, wobei diese Öffnungen einen Anschlag (52) tragen, der dergestalt ist, dass der freie Rand (50) der Elementarklappe der Öffnung gegenüber in der verschließenden Stellung der Elementarklappe in Kontakt mit diesem Anschlag kommt.

## Claims

1. A computer-equipment frame (10), said frame comprising an air extraction face adapted to receive a set of juxtaposed fans (16a, 16b, 16c, 16d), the fans being adapted to create a unidirectional flow of air from an inner side (28) of the frame towards an outer side (30) of this same frame,
the frame comprising a non-return plate (26) arranged against the air extraction face, said non-return plate comprising a single-piece sheet (32) made of a flexible material, configured as a two-dimensional network of non-articulated, deformable elementary flaps (34), each defined by a notch in the sheet of flexible material along a non-closed contour (36), such that a bridge of material (38) remains between the elementary flap and the remaining of the sheet, the contour of the notched region defining an airway (40) and each elementary flap being deformable between:
- an opening position in which the elementary flap is bent towards the outer side, away from the remaining of the sheet, hence clearing the airway (40) formed by the notched region of the sheet,
the non-return plate then letting the flow of air pass through from the inner side to the outer side of the frame under the effect of an overpressure on the inner side; and
- a closing position in which the elementary flap is not bent, or less bent than in the opening position, the non-return plate then blocking any flow of air between the inner side and the outer side of the frame under the effect of a counter-pressure on the outer side,
**characterized in that** the single-piece sheet (32) of the non-return plate (26) is mounted against the air extraction face of the frame so as to cover all the fans of said set of juxtaposed fans,
and **in that**, in closing position, the contour (36) of the elementary flap is in contact with the counterpart contour of the sheet, hence shutting the airway formed by the notched region of the sheet.

2. The frame of claim 1, wherein each individual flap (34) forms, in its free state, an angle (α) with respect to the plane of the remaining of the sheet (32), each individual flap having a length (l₁) higher than the length (l₂) of the counterpart edge of the notched region of the sheet.

3. The frame of claim 1, wherein each individual flap (34) is, in its free state, coplanar with the remaining of the sheet (32), each individual flap having a length equal to the length of the counterpart edge of the notched region of the sheet,
and wherein the non-return plate further comprises, on the inner side, a counter-sheet (46) made of a rigid material with openings (48) that are counterparts of the airways of the sheet of flexible material, these openings carrying a stop (52) such that the free edge (50) of the elementary flap opposite the opening comes into contact with this stop in the closing position of the elementary flap.
